# EUROPÄISCHE PATENTSCHRIFT

(11) **EP 3 622 330 B1**
(45) Veröffentlichungstag und Bekanntmachung des Hinweises auf die Patenterteilung: **20.12.2023**
(21) Anmeldenummer: 18727165.5
(22) Anmeldetag: 08.05.2018
(51) Int. Cl.: G01V 3/10, G01V 3/08, H03K 17/95

(54) **INDUKTIVER NÄHERUNGSSCHALTER**
INDUCTIVE PROXIMITY SWITCH
COMMUTATEUR DE PROXIMITÉ INDUCTIF

(30) Priorität: 08.05.2017 DE 102017109813
(43) Veröffentlichungstag der Anmeldung: 18.03.2020
(73) Patentinhaber: Pepperl+Fuchs SE, 68307 Mannheim (DE)
(72) Erfinder: BACHMANN, Martin, 67354 Römerberg (DE); HUBER, Olaf, 68307 Mannheim (DE)
(74) Vertreter: Schiffer, Axel Martin
(86) Internationale Anmeldenummer: PCT/EP2018/061790
(87) Internationale Veröffentlichungsnummer: WO 2018/206541

(56) Entgegenhaltungen:
- EP-A2- 0 316 914
- WO-A1-2016/058842
- DE-A1- 3 225 166
- DE-A1-102009 049 821
- DE-A1-102012 202 825
- US-A1- 2014 285 206

## Beschreibung

Die vorliegende Erfindung betrifft einen induktiven Näherungsschalter nach dem Oberbegriff des Anspruchs 1.

Ein gattungsgemäßer induktiver Näherungsschalter weist folgende Komponenten auf: eine Primärspule zum Erzeugen eines magnetischen Wechselfelds, einem Oszillator zum Antreiben der Primärspule, eine Steuer- Auswerteeinheit, die mit dem Oszillator wirkungsmäßig verbunden ist und eingerichtet ist zum Erfassen und Auswerten einer Amplitude und einer Phasenlage eines Stroms in der Primärspule und zum Ausgeben eines Detektionssignals in Abhängigkeit des erfassten Stroms in der Primärspule, und mindestens eine Kompensationsspule zum Manipulieren des durch die Primärspule erzeugten magnetischen Wechselfelds.

Ein Näherungsschalter mit diesen Merkmalen ist beispielsweise in DE 10 2006 053 023 A1 offenbart. Bei dem dort beschriebenen Näherungsschalter ist eine Sendespule gegensinnig zur Kompensationsspule geschaltet und Sendespule und Kompensationsspule werden von einem gemeinsamen Wechselspannungsgenerator betrieben. Die Möglichkeiten, das Magnetfeld in der näheren Umgebung des Näherungsschalters zu beeinflussen, sind deshalb begrenzt.

In WO 2014/053240 A2 ist ein induktiver Näherungsschalter beschrieben, bei dem ein Strom, der in einer Empfangsspule aufgrund elektromagnetischer Beaufschlagung durch eine Primärspule induziert wird, durch Einspeisen von Kompensationsströmen zu Null geregelt wird. Das Messprinzip besteht darin, die Kompensationsströme abzufragen, um dadurch Unterschiede bei Anwesenheit von nachzuweisenden Objekten festzustellen.

In WO 2012/104086 A2 ist ein Metalldetektor zur Ortung metallischer Objekte offenbart, bei dem Ströme in mindestens 2 Sendespule so zueinander geregelt werden können, dass ein von wenigstens einer Empfangsspule empfangenes Empfangsspulenausgangssignal oder Durchschnittswerte von Demodulationsphasen, die aus dem Empfangsspulenausgangssignal erzeugt werden, kontinuierlich, auch bei Anwesenheit eines nachzuweisenden Metalltargets, ähnlich wie bei WO 2014/053240 A2, zu Null geregelt werden.

In EP 0 316 914 A2 ist ein Näherungsschalter beschrieben, bei dem eine erste Spule und eine zweite Spule (Kompensationsspule) so verschaltet sind, dass sich die Spannungen an diesen Spulen, wenn kein nachzuweisendes Objekt vorhanden ist, gerade aufheben. Kommt ein nachzuweisendes Objekt in die Nähe der ersten Spule unterscheiden sich die Spannungen in den beiden Spulen und eine Auswerteschaltung liefert ein Nachweissignal.

DE 10 2009 049 821 A1 betrifft eine Vorrichtung zur Detektion von elektrisch leitfähigen Gegenständen, die auch als Näherungsschalter gebildet sein kann und bei der eine erste Spule mit einem Strompuls beaufschlagt und die Reaktion in weiteren Spulen in der Nähe in Abhängigkeit eines nachzuweisenden Objekts ausgewertet wird.

In WO 2016/058842 A1 ist ein Metalldetektor beschrieben, bei dem zum Lokalisieren eines metallischen Objekts zwei Spulen dergestalt angesteuert werden, dass ein feldfreier Bereich zwischen den beiden Spulen in einer festgelegten Weise verschoben wird.

Allgemeine Wirkmechanismen bei induktiven Näherungsschaltern sind beschrieben in: "Firmenschrift ifm electronic; Schulungsunterlagen efector 100 - Induktive Sensoren Stand März 2003".

Als eine Aufgabe der Erfindung kann angesehen werden, einen Näherungsschalter bereitzustellen, bei dem die magnetischen Wechselfelder besonders flexibel beeinflusst werden können.

Diese Aufgabe wird durch den Näherungsschalter mit den Merkmalen des Anspruchs 1 gelöst.

Der Näherungsschalter der oben angegebenen Art ist erfindungsgemäß dadurch weitergebildet, dass zur Ansteuerung der mindestens einen Kompensationsspule eine separate, insbesondere unabhängig von der Primärspule steuerbare Stromquelle vorhanden ist.

Vorteilhafte Weiterbildungen des erfindungsgemäßen Näherungsschalters werden in der folgenden Beschreibung, insbesondere mit Bezug auf die abhängigen Ansprüche und die Figuren, beschrieben.

Das Messprinzip eines induktiven Näherungsschalters besteht ganz allgemein zunächst darin, dass eine von einem Oszillator angetriebene Primärspule, die auch als Sendespule bezeichnet werden kann, ein magnetisches Wechselfeld in einen Überwachungsbereich aussendet und dass eine Wechselwirkung zwischen diesem magnetischen Wechselfeld und einem nachzuweisenden Objekt, das auch als Target bezeichnet wird, gemessen wird. Ein wesentlicher Effekt ist dabei, dass durch das magnetische Wechselfeld in einem metallischen Target Wirbelströme und damit Verluste entstehen, die dem Oszillator Energie entziehen.

Ganz prinzipiell kann mit induktiven Näherungsschaltern auch ein abstandsabhängiges Signal bereitgestellt werden. Weil dieses aber äußerst empfindlich von der genauen Relativpositionierung zwischen Target und Näherungsschalter abhängt, wird hiervon nur in Sondersituationen Gebrauch gemacht. In der Regel werden induktive Näherungsschalter als binär (ein/aus) schaltende Sensoren eingesetzt.

Bei der gängigsten Auswertemethode, die insbesondere bei dem erfindungsgemä-ßen Näherungsschalter zum Einsatz kommen kann, wird die Dämpfung des Oszillators durch das herannahende Target ausgewertet. Dabei schaltet der Näherungsschalter, wenn die Dämpfung durch das sich annähernde Target so groß wird, dass die Schwingungsamplitude unter einen Schwellwert sinkt. Dieses kann mit vergleichsweise einfachen elektronischen Mitteln realisiert werden.

Bei einer besonders bevorzugten Ausführungsvariante des erfindungsgemäßen induktiver Näherungsschalters ist die Steuer- und Auswerteeinheit dazu eingerichtet, festzustellen, wann der Strom in der Primärspule unter einen festzulegenden Schwellwert sinkt und in Abhängigkeit davon ein Ausgangssignal auszugeben. Prinzipiell ist es auch möglich, andere mit dem Strom in der Primärspule funktional monoton zusammenhängende Größen, wie beispielsweise den Energieinhalt der Primärspule, abzufragen und ein Ausgangssignal auszugeben, wenn dieser unter einen Schwellwert sinken.

Durch die erfindungsgemäß vorhandenen separat und unabhängig ansteuerbaren Kompensationsspulen wird die Qualität der Messung verbessert. Für das Messprinzip als solches sind die Kompensationsspulen und deren unabhängige Ansteuerung aber nicht notwendig.

Der Oszillator zum Antreiben der Primärspule weist in der Regel einen Schwingkreis und einen rückgekoppelten Verstärker auf. Grundsätzlich kann die Primär- oder Sendespule dabei auch durch die Induktivität des Schwingkreises selbst gebildet sein.

Bei Näherungsschaltern, bei denen das grundlegende Messsignal aus der Dämpfung eines Oszillators durch ein herannahendes Target abgeleitet wird, ist die Primärspule keine Sendespule im eigentlichen Sinn. Wenn gleichwohl von einer Sendespule gesprochen wird, bedeutet das nicht, dass eine Empfangsspule vorhanden sein muss. Tatsächlich ist bei Näherungsschaltern, die eine Dämpfung auswerten, keine Empfangsspule vorhanden. Ebenso wenig bedeutet die Verwendung des Begriffs Primärspule, dass notwendig eine Sekundärspule vorhanden sein muss. Die Spulen, bei Näherungsschaltern, die eine Dämpfung auswerten, zum Messen verwendet werden, könnten zutreffender als Mess- oder Sensorspulen bezeichnet werden.

Als Steuer- und Auswerteeinheit werden diejenigen elektronischen Komponenten bezeichnet, mit denen die notwendigen Steuerungen und Auswertungen vorgenommen werden, insbesondere also die Auswertung der Änderung der Oszillatoreigenschaften bei sich annäherndem Target. Die Steuer- und Auswerteeinheit kann durch analog- und/oder digital-elektronische Komponenten gebildet sein. Die Komponenten der Steuer- und Auswerteeinheit, die zum Feststellen von Amplitude und Phasenlage des Stroms in der Primärspule dienen, können dabei auch in dem Oszillator angeordnet oder Teile des Oszillators sein.

Mit dem Begriff des Detektionssignals wird dasjenige Signal bezeichnet, das der Näherungsschalter in Abhängigkeit der Annäherung eines Targets ausgibt. Dabei kann es sich in Sonderfällen prinzipiell auch um ein analoges, also abstandsabhängiges, Signal handeln. In der Regel ist das Detektionssignal aber ein binäres Signal, also ein Ein/Aus-Signal, welches angibt, ob sich ein Target näher oder weiter als ein bestimmter Schaltabstand am Näherungsschalter befindet.

Als Kompensationsspulen werden weitere Spulen bezeichnet, die Einfluss nehmen können, auf das von der Primärspule erzeugte magnetische Wechselfeld, aber für das eigentliche Messprinzip nicht konstitutiv sind.

Mit dem Merkmal, dass eine separate steuerbare Stromquelle vorhanden sein soll, ist ganz allgemein gemeint, dass der Strom, mit dem die mindestens eine Kompensationsspule angetrieben wird, nicht in einer festen, unveränderbaren und in diesem Sinn starren Beziehung zu dem Strom durch die Primärspule steht. Diese Stromquelle soll steuerbar in dem Sinn sein, dass der Strom durch die Kompensationsspule oder Kompensationsspulen variabel einstellbar ist. Wesentlich ist also, dass die mindestens eine Kompensationsspule völlig unabhängig durch die separate Stromquelle angesteuert werden kann.

Die Erfindung hat erkannt, dass die starre Verknüpfung des Antriebs der Kompensationsspulen mit demjenigen der Sende- oder Primärspule zwar eine grobe Kompensierung von Effekten eines Gehäuses oder von bestimmten Einbaumaterialien ermöglicht, dass diese unerwünschten Effekte aber deutlich besser reduziert werden können bei flexiblerer Ansteuerung der mindestens einen Kompensationsspule.

Als ein Kerngedanke der vorliegenden Erfindung kann also angesehen werden, das Antreiben der mindestens einen Kompensationsspule flexibler und insbesondere unabhängig von einer Speisung der Primärspule zu gestalten und hierzu, in Gestalt der separaten steuerbaren, unabhängig ansteuerbaren, Stromquelle, die geeigneten technischen Mittel bereitzustellen.

Als wesentlicher Vorteil des erfindungsgemäßen Näherungsschalters kann angesehen werden, dass dieser im Vergleich zu aus dem Stand der Technik bekannten Geräten deutlich weniger störanfällig ist gegenüber Materialien und Teilen, die sich in einer Umgebung des Näherungsschalters befinden. Besonders wichtig ist dabei, dass der erfindungsgemäße Näherungsschalter auch in unterschiedlichen Einbausituationen individuell eingestellt und betrieben werden kann.

Bei besonders bevorzugten Varianten des erfindungsgemäßen Näherungsschalters sind die steuerbaren Stromquellen zur Steuerung einer Amplitude und einer Phasenlage des jeweiligen Kompensationsspulenstroms eingerichtet.

Grundsätzlich wird der Hauptgedanke der vorliegenden Erfindung verwirklicht, wenn eine einzige Kompensationsspule und eine dazugehörige separate steuerbare, insbesondere unabhängig ansteuerbare, Stromquelle vorhanden sind. Die oben angegebenen erfindungsgemäßen Vorteile werden aber in besonderer Weise bei Varianten erreicht, bei denen mehrere Kompensationsspulen, insbesondere zwei Kompensationsspulen, vorhanden sind.

Prinzipiell ist es möglich, dass von ein und derselben steuerbaren Stromquelle mehrere Kompensationsspulen angetrieben werden. Noch mehr Möglichkeiten im Hinblick auf die individuelle Anpassung des erfindungsgemäßen induktiven Näherungsschalters erhält man, wenn für jede der Kompensationsspulen eine eigene separate steuerbare, insbesondere unabhängig ansteuerbare, Stromquelle vorhanden ist.

Im Hinblick auf die konkrete geometrische Ausgestaltung und die konkrete Positionierung der Kompensationsspulen relativ zur Primärspule besteht grundsätzlich Gestaltungsfreiheit. Hierin manifestiert sich gerade ein besonderer Vorteil der vorliegenden Erfindung, weil die räumlichen Verteilungen der magnetischen Wechselfelder aufgrund dieser Gestaltungsfreiheit besonders gut modelliert werden können.

Als besonders vorteilhaft haben sich dabei zylindersymmetrische Anordnungen der Primärspule und der Kompensationsspule oder Kompensationsspulen erwiesen. Beispielsweise kann eine Kompensationsspule die Primärspule, insbesondere vollständig, umgeben. Dabei ist insbesondere an Anordnungen gedacht, bei denen die Primärspule an einer Stirnseite eines im Wesentlichen röhrenförmigen Gehäuses so angeordnet ist, dass eine Zylinderachse der Primärspule koaxial mit einer Achse des röhrenförmigen Gehäuses verläuft und bei denen eine Kompensationsspule die so positionierte Primärspule radial außenliegend umgibt.

Eine die Primärspule umgebenden Kompensationsspule ist besonders wirksam, wenn die Kompensationsspule in einer Axialrichtung eine Ausdehnung aufweist, die größer ist oder gleich wie eine Ausdehnung der Primärspule oder eines Spulenkerns der Primärspule in dieser Axialrichtung.

Als besonders zweckmäßig haben sich außerdem Anordnungen erwiesen, bei denen mindestens eine Kompensationsspule in einer Axialrichtung hinter der Primärspule angeordnet ist.

Eine in Axialrichtung hinter der Primärspule positionierte Kompensationsspule ist besonders wirksam, wenn diese Kompensationsspule einen Durchmesser aufweist, der größer ist als oder gleich groß ist wie ein Durchmesser der Primärspule oder der Durchmesser eines Spulenkerns der Primärspule.

Grundsätzlich kann die Erfindung bei induktiven Näherungsschaltern ohne Spulenkern verwirklicht werden. Bei besonders zweckmäßigen Varianten ist die weist Primärspule aber zum Formen der Feldverteilung des magnetischen Wechselfeld und zu dessen Verstärkung einen Spulenkern auf. Beispielsweise kann der Spulenkern ein Schalenkern von grundsätzlich bekannter Form und aus einem grundsätzlich bekannt Material, beispielsweise Ferrit, sein.

Besonders vorteilhaft ist der Spulenkern ein Schalenkern, dessen Form an die Form der Kompensationsspulen angepasst ist.

Bezüglich des Gehäuses, in dem der erfindungsgemäße induktive Näherungsschalter aufgenommen ist, besteht grundsätzlich Gestaltungsfreiheit. Als besonders zweckmäßig haben sich aber Varianten erwiesen, bei denen die Primärspule in einem röhrenförmigen Gehäuse an einer Stirnseite positioniert ist.

Beispielsweise können die Primärspule, die Kompensationsspulen und die steuerbaren Stromquellen in einem quaderförmigen oder zylinderförmigen, insbesondere kreiszylinderförmigen, Gehäuse angeordnet sein.

Die Beeinflussungen des von der Primärspule ausgesandten magnetischen Wechselfelds durch das Gehäuse sind bei solchen Gehäusegeometrien besonders gering.

Ebenso besteht Gestaltungsfreiheit im Hinblick auf das Material des Gehäuses. Dieses kann aus Kunststoff und/oder prinzipiell aber auch aus Metall gefertigt sein. Ein besonderer Vorteil der Erfindung ist, dass mithilfe der steuerbaren Stromquelle für die mindestens eine Kompensationsspule flexibel auf unterschiedliche Einbausituationen und Gehäusematerialien reagiert werden kann.

Bei weiteren besonders bevorzugten Varianten der Erfindung ist die, insbesondere analoge und/oder digitale, Steuer- und Auswerteeinheit auch zum Ansteuern der steuerbaren Stromquellen eingerichtet. Beispielsweise kann diese Ansteuerung softwaregesteuert erfolgen.

In diesem Zusammenhang ist es weiterhin bevorzugt, wenn die Steuer- und Auswerteeinheit eine programmierbare logische Komponente, insbesondere einen Mikrocontroller, insbesondere mit analoger und digitaler Funktionalität, aufweist.

Weitere Eigenschaften und Vorteile der Erfindung werden im Folgenden mit Bezug auf die beigefügte schematische Figur erläutert. Darin zeigt:

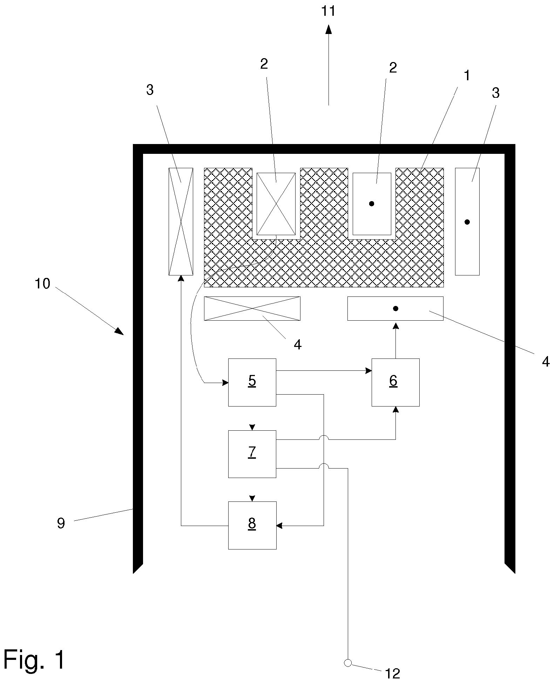

- Figur 1:: ein Ausführungsbeispiel eines erfindungsgemäßen induktiven Näherungsschalters.

Das in Figur 1 schematisch dargestellte Ausführungsbeispiel eines erfindungsgemä-ßen induktiven Näherungsschalters 10 weist als wesentliche Komponenten eine Primärspule 2, einen Oszillator 5, eine erste Kompensationsspule 3 mit einer zugeordneten ersten steuerbaren Stromquelle 8 und eine zweite Kompensationsspule 4 mit einer zugeordneten zweiten steuerbaren Stromquelle 6 auf. Diese Komponenten sind in einem Gehäuse 9, das beispielsweise aus Metall und/oder aus Kunststoff bestehen kann, untergebracht.

Die Primärspule 2, die zur Erzeugung eines magnetischen Wechselfeld dient, ist in einem Schalenkern 1 untergebracht. Innerhalb des Gehäuses 9, dass beispielsweise eine kubische oder zylindrische Form aufweisen kann, ist der Schalenkern 1 mit der Primärspule 2 unmittelbar an einer Stirnseite angeordnet. Das magnetische Wechselfeld kann so gut nach außen austreten. Die erste Kompensationsspule 3 befindet sich radial außerhalb des Schalenkerns 1 und umgibt diesen in Umfangsrichtung vollständig. In Axialrichtung, die in Figur 1 mit dem Bezugszeichen 11 gekennzeichnet ist, ist die Ausdehnung der ersten Kompensationsspule 3 etwa so groß wie diejenige des Schalenkerns 1. Es ist aber darauf hinzuweisen, dass im Hinblick auf die konkrete Geometrie und die konkrete Positionierung der Kompensationsspulen grundsätzlich eine große Gestaltungsfreiheit besteht. Beispielsweise müssen die Kompensationsspulen nicht notwendig in der in der Figur dargestellten Weise bündig relativ zur Primärspule gebildet und positioniert sein.

Die zweite Kompensationsspule 4 ist eine flache Spule und befindet sich in Axialrichtung 11 gesehen hinter dem Schalenkern 1. Die zweite Kompensationsspule 4 überdeckt im Wesentlichen die gesamte Rückseite des Schalenkerns 1.

In dem Oszillator 5 sind elektronische Mittel vorhanden, mit denen ein Strom durch die Primärspule 2 erfasst werden kann. Insoweit überlappen Komponenten des Oszillators aus 5 und der Steuer- und Auswerteeinheit 7. Zum Auswerten dieses Stroms durch die Primärspule 2 ist der Oszillator 5 mit der Steuer- und Auswerteeinheit 7 verbunden.

Im gezeigten Ausführungsbeispiel sind die erste steuerbare Stromquelle 6 und die zweite steuerbare Stromquelle 8 mit dem Oszillator 5 verbunden. Das bedeutet, dass jedenfalls die Frequenz des Stroms durch die erste Kompensationsspule 3 und die zweite Kompensationsspule 4 durch den Oszillator 5 vorgegeben wird.

Die erste steuerbare Stromquelle 8 und die zweite steuerbare Stromquelle 6 ermöglichen darüber hinaus ein jeweils individuelles Einstellen von Amplitude und relativer Phasenlage des Stroms durch die erste Kompensationsspule 3 beziehungsweise die zweite Kompensationsspule 4. Diese weiteren Steuerungen können beispielsweise, wie beim vorliegenden Ausführungsbeispiel durch entsprechende Pfeile veranschaulicht, durch die Steuer- und Auswerteeinheit 7 durchgeführt werden. Beispielsweise kann es sich bei der Steuer- und Auswerteeinheit 7 um einen Mikrocontroller handeln, der analoge und digitale Funktionalitäten bereitstellen kann. Zum Ausgeben eines bevorzugt binären Schaltsignals ist eine Schnittstelle 12 (schematisch dargestellt) vorhanden, die beispielsweise mit einem Bussystem verbunden sein kann.

Die Kompensationsspule in 3 und 4 dienen zur lokalen Feldverdrängung des durch die Primärspule 2 erzeugten magnetischen Wechselfelds. Die elektrischen Größen des Primärspulenstroms, insbesondere Amplitude und Phasenlage, werden dabei erfasst. Die Kompensationsspulen 3 und 4 erzeugen, angesteuert durch die steuerbaren Stromquellen 6 beziehungsweise 8, lokale Kompensationsfelder. Durch die Möglichkeit der Einstellung von Amplitude und Phasenlage bei den Stromquellen 6 beziehungsweise 8 sind im Hinblick auf angrenzende Einbaumaterialien, beispielsweise am Gehäuserand, äußerst flexible Anpassungen möglich. Als besonderer Vorteil wird bei der Erfindung erreicht, dass sich die genannten Einbaumaterialien an den Rändern des Gehäuses, die ohne Kompensation von der Primärspule 2 erfasst würden, besonders gut ausblenden lassen und demgemäß von der Auswerteeinheit 7 nicht mehr oder nur noch sehr geringfügig erfasst werden, ohne dass die Nachweisempfindlichkeit für die eigentlich interessierenden Targets leiden würde.

Mit der vorliegenden Erfindung wird eine neuartiger induktiver Näherungsschalter bereitgestellt, bei dem durch die Grundidee der individuellen Anpassung des Stroms der Kompensationsspulen, die insbesondere unabhängig von einem Primärstrom durch die Sendespule erfolgt, deutliche Verbesserungen erreicht werden im Hinblick auf das Ausblenden von Gegenständen und Materialien in der Umgebung des Näherungsschalters. Die Zuverlässigkeit des induktiven Näherungsschalters kann so gesteigert werden.

### Bezugszeichenliste

- 1: Spulenkern
- 2: Primärspule
- 3: Kompensationsspule
- 4: Kompensationsspule
- 5: Oszillator
- 6: steuerbare Stromquelle
- 7: Steuer- und Auswerteeinheit
- 8: steuerbare Stromquelle
- 9: Gehäuse
- 10: Induktiver Näherungsschalter
- 11: Axialrichtung
- 12: Schnittstelle

## Patentansprüche

1. Induktiver Näherungsschalter
mit einer Primärspule (2) zum Erzeugen eines magnetischen Wechselfelds, mit einem Oszillator (5) zum Antreiben der Primärspule (2),
mit einer Steuer- und Auswerteeinheit (7), die mit dem Oszillator (5) wirkungsmäßig verbunden ist und eingerichtet ist zum Erfassen und Auswerten einer Amplitude und einer Phasenlage eines Stroms in der Primärspule (2) und zum Ausgeben eines Detektionssignals in Abhängigkeit des erfassten Stroms in der Primärspule,
mit mindestens einer Kompensationsspule (3) zum Manipulieren des durch die Primärspule (2) erzeugten magnetischen Wechselfelds,
**dadurch gekennzeichnet,**
**dass** zur Ansteuerung der mindestens einen Kompensationsspule (3, 4) eine separate steuerbare Stromquelle (6, 8) vorhanden ist, die dazu dient, die Kompensationsspule unabhängig von der Primärspule anzutreiben, um Effekte eines Gehäuses des Näherungsschalters und/oder von unterschiedlichen Einbausituationen des Näherungsschalters zu kompensieren.

2. Induktiver Näherungsschalter nach Anspruch 1,
**dadurch gekennzeichnet,**
**dass** mehrere Kompensationsspulen (3, 4) vorhanden sind.

3. Induktiver Näherungsschalter nach Anspruch 2,
**dadurch gekennzeichnet**
**dass** für jede der Kompensationsspulen (3, 4) eine eigene separate steuerbare Stromquelle (6, 8) vorhanden ist.

4. Induktiver Näherungsschalter nach Anspruch 3,
**dadurch gekennzeichnet,**
**dass** die, insbesondere analoge und/oder digitale, Steuer- und Auswerteeinheit (7), auch zum Ansteuern der steuerbaren Stromquellen (6, 8), eingerichtet ist.

5. Induktiver Näherungsschalters nach einem der Ansprüche 3 oder 4,
**dadurch gekennzeichnet,**
**dass** die Primärspule (2), die Kompensationsspulen (3, 4) und die steuerbaren Stromquellen (6, 8) in einem quaderförmigen oder zylinderförmigen, insbesondere kreiszylinderförmigen, Gehäuse (9) angeordnet sind.

6. Induktiver Näherungsschalters nach Anspruch 5,
**dadurch gekennzeichnet,**
**dass** das Gehäuse aus Kunststoff und/oder aus Metall gefertigt ist.

7. Induktiver Näherungsschalter nach einem der Ansprüche 5 oder 6,
**dadurch gekennzeichnet,**
**dass** das Gehäuse röhrenförmig ist und dass die Primärspule (2) in dem röhrenförmigen Gehäuse (9) an einer Stirnseite positioniert ist.

8. Induktiver Näherungsschalter nach einem der Ansprüche 3 bis 7,
**dadurch gekennzeichnet,**
**dass** die steuerbaren Stromquellen (6, 8) zur Steuerung einer Amplitude und/oder einer Phasenlage des Kompensationsspulenstroms eingerichtet sind.

9. Induktiver Näherungsschalter nach einem der Ansprüche 1 bis 8,
**dadurch gekennzeichnet,**
**dass** eine Kompensationsspule (3) die Primärspule (2), insbesondere vollständig, umgibt.

10. Induktiver Näherungsschalter nach Anspruch 9,
**dadurch gekennzeichnet,**
**dass** die die Primärspule (2) umgebende Kompensationsspule (3) in einer Axialrichtung eine Ausdehnung aufweist, die größer ist oder gleich groß ist wie eine Ausdehnung der Primärspule (2) oder eines Spulenkerns der Primärspule in dieser Axialrichtung.

11. Induktiver Näherungsschalter nach einem der Ansprüche 1 bis 10,
**dadurch gekennzeichnet,**
**dass** eine Kompensationsspule (4) in einer Axialrichtung hinter der Primärspule (2) angeordnet ist.

12. Induktiver Näherungsschalters nach Anspruch 11,
**dadurch gekennzeichnet,**
**dass** die hinter der Primärspule (2) angeordnete Kompensationsspule (4) einen Durchmesser aufweist, der größer ist als oder gleich groß ist wie ein Durchmesser der Primärspule oder der Durchmesser eines Spulenkerns der Primärspule.

13. Induktiver Näherungsschalter nach einem der Ansprüche 1 bis 12,
**dadurch gekennzeichnet,**
**dass** die Primärspule (2) einen Spulenkern aufweist.

14. Induktiver Näherungsschalters nach Anspruch 13,
**dadurch gekennzeichnet,**
**dass** der Spulenkern ein Schalenkern ist.

15. Induktiver Näherungsschalters nach einem der Ansprüche 1 bis 14,
**dadurch gekennzeichnet,**
**dass** die Steuer- und Auswerteeinheit (7) eine programmierbare logische Komponente, insbesondere einen Mikrocontroller, insbesondere mit analoger und digitaler Funktionalität, aufweist.

16. Induktiver Näherungsschalter nach einem der Ansprüche 1 bis 15,
**dadurch gekennzeichnet,**
**dass** die Steuer- und Auswerteeinheit dazu eingerichtet ist, festzustellen, wann der Strom in der Primärspule unter einen festzulegenden Schwellwert sinkt und in Abhängigkeit davon ein Ausgangssignal auszugeben.

## Claims

1. An inductive proximity switch
having a primary coil (2) for generating an alternating magnetic field,
with an oscillator (5) for driving the primary coil (2),
with a control and evaluation unit (7), which is operatively connected to the oscillator (5) and is equipped to acquire and evaluate an amplitude and a phase position of a current in the primary coil (2) and for outputting a detection signal depending on the acquired current in the primary coil,
with at least one compensation coil (3) for manipulating the alternating magnetic field generated by the primary coil (2),
**characterized in that**,
a separate controllable current source (6, 8) is present for controlling the at least one compensation coil (3, 4), which current source is used to drive the compensation coil independently of the primary coil in order to compensate for effects of a housing of the proximity switch and/or of different installation situations of the proximity switch.

2. The inductive proximity switch according to claim 1,
**characterized in that**,
a plurality of compensation coils (3, 4) are present.

3. The inductive proximity switch according to claim 2,
**characterized in that**,
a separate controllable current source (6, 8) is present for each of the compensation coils (3, 4).

4. The inductive proximity switch according to claim 3,
**characterized in that**,
the, in particular analog and/or digital, control and evaluation unit (7) is also equipped to control the controllable current sources (6, 8).

5. The inductive proximity switch according to one of the claims 3 or 4,
**characterized in that**,
the primary coil (2), the compensation coils (3, 4) and the controllable current sources (6, 8) are arranged in a rectangular or cylindrical housing, in particular in a housing (9) in the shape of a circular cylinder.

6. The inductive proximity switch according to claim 5,
**characterized in that**,
the housing is made of plastic and/or of metal.

7. The inductive proximity switch according to claim 5 or 6,
**characterized in that**,
the housing (9) is a tubular housing (9) and the primary coil (2) is positioned in the tubular housing (9) at a front side.

8. The inductive proximity switch according to one of the claims 3 to 7,
**characterized in that**,
the controllable current sources (6, 8) are equipped to control an amplitude and/or a phase position of the compensation coil current.

9. The inductive proximity switch according to any of claims 1 to 8,
**characterized in that**,
a compensation coil (3) surrounds the primary coil (2), in particular completely.

10. The inductive proximity switch according to claim 9,
**characterized in that**,
the compensation coil (3) surrounding the primary coil (2) has an expansion in an axial direction which is greater than or equal to an expansion of the primary coil (2) or of a coil core of the primary coil in its axial direction.

11. The inductive proximity switch according to any of claims 1 to 10,
**characterized in that**,
a compensation coil (4) is arranged in an axial direction behind the primary coil (2).

12. The inductive proximity switch according to claim 11,
**characterized in that**,
the compensation coil (4) arranged behind the primary coil (2) has a diameter that is greater than or equal to a diameter of the primary coil or the diameter of a coil core of the primary coil.

13. The inductive proximity switch according to any of claims 1 to 12,
**characterized in that**,
the primary coil (2) has a coil core.

14. The inductive proximity switch according to claim 13,
**characterized in that**,
the coil core is a pot core.

15. The inductive proximity switch according to one of the claims 1 to 14,
**characterized in that**,
the control and evaluation unit (7) has a programmable logical component, in particular a microcontroller, in particular with analog and digital functionality.

16. The inductive proximity switch according to any of claims 1 to 15,
**characterized in that**,
the control and evaluation unit is equipped to determine when the current in the primary coil falls below a threshold to be specified and depending on that, to output an output signal.

## Revendications

1. Commutateur de proximité inductif comprenant
une bobine primaire (2) pour la production d'un champ alternatif magnétique,
un oscillateur (5) pour l'entraînement de la bobine primaire (2),
une unité de commande et d'analyse (7) qui est fonctionnellement reliée à l'oscillateur (5) et aménagée pour la saisie et l'analyse d'une amplitude et d'une position de phase d'un courant dans la bobine primaire (2) et pour l'émission d'un signal de détection en fonction du courant saisi dans la bobine primaire, au moins une bobine de compensation (3) pour la manipulation du champ alternatif magnétique produit par la bobine primaire (2),
**caractérisé en ce que**
pour le pilotage de la au moins une bobine de compensation (3, 4) est présente une source de courant (6, 8) pouvant être commandée séparément, qui sert à entraîner la bobine de compensation indépendamment de la bobine primaire, pour compenser des effets d'un logement du commutateur de proximité et/ou de diverses situations de montage du commutateur de proximité.

2. Commutateur de proximité inductif selon la revendication 1,
**caractérisé en ce que**
plusieurs bobines de compensation (3, 4) sont présentes.

3. Commutateur de proximité inductif selon la revendication 2,
**caractérisé en ce que**
pour chacune des bobines de compensation (3, 4) est présente une source de courant (6, 8) pouvant être commandée séparément et qui lui est propre.

4. Commutateur de proximité inductif selon la revendication 3,
**caractérisé en ce que**
l'unité de commande et d'analyse (7), en particulier analogique et/ou numérique, est également aménagée pour le pilotage des sources de courant (6, 8) pouvant être commandées.

5. Commutateur de proximité inductif selon l'une des revendications 3 ou 4,
**caractérisé en ce que**
la bobine primaire (2), les bobines de compensation (3, 4) et les sources de courant (6, 8) pouvant être commandées sont agencées dans un logement (9) en forme de parallélépipède ou de cylindre, en particulier de cylindre circulaire.

6. Commutateur de proximité inductif selon la revendication 5,
**caractérisé en ce que**
le logement est fabriqué en matière plastique et/ou en métal.

7. Commutateur de proximité inductif selon l'une des revendications 5 ou 6,
**caractérisé en ce que**
le logement est un logement (9) tubulaire et la bobine primaire (2) est positionnée dans le logement (9) tubulaire sur un côté frontal.

8. Commutateur de proximité inductif selon l'une des revendications 3 à 7,
**caractérisé en ce que**
les sources de courant (6, 8) pouvant être commandées sont aménagées pour la commande d'une amplitude et/ou d'une position de phase du courant de bobine de compensation.

9. Commutateur de proximité inductif selon l'une des revendications 1 à 8,
**caractérisé en ce que**
une bobine de compensation (3) entoure la bobine primaire (2), en particulier complètement.

10. Commutateur de proximité inductif selon la revendication 9,
**caractérisé en ce que**
la bobine de compensation (3) entourant la bobine primaire (2) présente dans une direction axiale une extension qui est plus grande ou aussi grande qu'une extension de la bobine primaire (2) ou d'un noyau de bobine de la bobine primaire dans cette direction axiale.

11. Commutateur de proximité inductif selon l'une des revendications 1 à 10,
**caractérisé en ce que**
une bobine de compensation (4) est agencée derrière la bobine primaire (2) dans une direction axiale.

12. Commutateur de proximité inductif selon la revendication 11,
**caractérisé en ce que**
la bobine de compensation (4) agencée derrière la bobine primaire (2) présente un diamètre qui est plus grand ou aussi grand qu'un diamètre de la bobine primaire ou un diamètre d'un noyau de bobine de la bobine primaire.

13. Commutateur de proximité inductif selon l'une des revendications 1 à 12,
**caractérisé en ce que**
la bobine primaire (2) présente un noyau de bobine.

14. Commutateur de proximité inductif selon la revendication 13,
**caractérisé en ce que**
le noyau de bobine est un noyau en forme de coquille.

15. Commutateur de proximité inductif selon l'une des revendications 1 à 14,
**caractérisé en ce que**
l'unité de commande et d'analyse (7) présente une composante logique programmable, en particulier un microcontrôleur, en particulier avec une fonctionnalité analogique et numérique.

16. Commutateur de proximité inductif selon l'une des revendications 1 à 15,
**caractérisé en ce que**
l'unité de commande et d'analyse est aménagée pour déterminer quand le courant dans la bobine primaire descend en-dessous d'une valeur seuil à fixer et en fonction de cela émettre un signal de sortie.
